# NOUVEAU FASCICULE DE BREVET EUROPEEN

(11) **EP 2 227 829 B2**
(45) Date de publication et mention de la décision concernant l'opposition: **16.12.2015**
(45) Mention de la délivrance du brevet: 31.08.2011
(21) Numéro de dépôt: 08864573.4
(22) Date de dépôt: 02.12.2008
(51) Int. Cl.: H01L 31/0224, H01L 31/0336

(54) **PERFECTIONNEMENTS APPORTES A DES ELEMENTS CAPABLES DE COLLECTER DE LA LUMIERE**
VERBESSERUNGEN AN ELEMENTEN, DIE ZUM SAMMELN VON LICHT FÄHIG SIND
IMPROVEMENTS TO ELEMENTS CAPABLE OF COLLECTING LIGHT

(30) Priorité: 07.12.2007 FR 0759632
(43) Date de publication de la demande: 15.09.2010
(73) Titulaire: Saint-Gobain Glass France, 92400 Courbevoie (FR)
(72) Inventeur: AUVRAY, Stéphane, F-92150 Suresnes (FR); DUPUY, Delphine, F-91300 Massy (FR); JANKE, Nikolas, 52134 Herzogenrath (DE)
(74) Mandataire: Neuviale, Bertrand
(86) Numéro de dépôt international: PCT/FR2008/052187
(87) Numéro de publication internationale: WO 2009/080931

(56) Documents cités:
- EP-A1- 1 833 096
- EP-B- 0 360 403
- WO-A2-2008/156521
- DE-C1- 4 442 824
- FR-A- 2 832 706
- JP-A- 2004 140 307
- PROBST ET AL: "New developments in Cu(In,Ga)(S, Se)2 thin film modules formed by rapid thermal processing of stacked elemental layers" SOLAR ENERGY MATERIALS AND SOLAR CELLS, ELSEVIER SCIENCE PUBLISHERS, AMSTERDAM, NL, vol. 90, no. 18-19, 23 novembre 2006 (2006-11-23), pages 3115-3123, XP005645499 ISSN: 0927-0248
- SINGH V P ET AL: "Thin film CdTe-CdS heterojunction solar cells on lightweight metal substrates" SOLAR ENERGY MATERIALS AND SOLAR CELLS, ELSEVIER SCIENCE PUBLISHERS, AMSTERDAM, NL, vol. 59, no. 1-2, 1 septembre 1999 (1999-09-01), pages 145-161, XP004181624 ISSN: 0927-0248
- KADAM A.A. ET AL: 'Study of molybdenum back contact layer to achieve adherent and efficient CIGS2 absorber thin-film solar cells' JOURNAL OF VACUUM SCIENCE AND TECHNOLOGY vol. 23, no. 4, 28 Juin 2005, pages 1197 - 1201
- SCOFIELD J.H. ET AL: 'Sputtered Molybdenum Bilayer Back Contact for Copper Indium Diselenide-Based Polycrystalline Thin-Film Solar Cells' THIN SOLID FILMS vol. 260, no. 1, 01 Mai 1995, pages 26 - 31
- POWALLA M. ET AL: 'Scaling up issues of CIGS solar cells' THIN SOLID FILMS vol. 361-362, no. 1, 01 Février 2000, pages 540 - 546
- ROCKETT A. ET AL: 'Na incorporation in Mo and CulnSe2 from production processes' SOLAR ENERGY MATERIALS & SOLAR CELLS vol. 59, no. 3, 01 Octobre 1999, pages 255 - 264
- ROMEO A. ET AL: 'Development of Thin-film CU(In, Ga)Se2 and CdTe Solar Cells' PROGRESS IN PHOTOVOLTAICS: RESEARCH AND APPLICATIONS vol. 12, no. 23, 01 Mars 2004, pages 93 - 111
- MENNER R. ET AL: 'Investigations on Sputter-Deposited Molybdenum Back Contacts for Cu(In,Ga)Se2' PROC. 13TH EUROPEAN PHOTOVOLTAIC SOLAR ENERGY 27 Octobre 1995, pages 2067 - 2071

## Description

La présente invention est relative à des perfectionnements apportés à des éléments capables de collecter de la lumière ou plus généralement à tout dispositif électronique telle qu'une cellule solaire à base de matériaux semi-conducteurs.

Il est connu que des éléments capables de collecter de la lumière du type cellules solaires photovoltaïques à couches minces comportent une couche d'agent absorbant, au moins une électrode disposée sur le côté d'incidence de la lumière à base d'un matériau conducteur de l'électricité, et une électrode arrière à base d'un matériau également conducteur, cette électrode arrière pouvant être relativement épaisse et opaque. Elle doit se caractériser essentiellement par une résistance électrique de surface aussi faible que possible et une bonne adhérence à la couche d'absorbeur ainsi que le cas échéant au substrat. Le document EP-B-0360403 décrit un substrat en verre avec une électrode de molybdène.

Les composés ternaires chalcopyrites qui peuvent jouer le rôle d'absorbeur contiennent généralement du cuivre, de l'indium et du sélénium. Il s'agit là de ce que l'on appelle des couches d'agent absorbant CISe₂. On peut aussi ajouter à la couche d'agent absorbant du gallium (ex : Cu(In,Ga)Se₂ ou CuGaSe₂), de l'aluminium (ex : Cu(In,Al)Se₂), ou du soufre (ex : CuIn(Se,S). On les désigne en général et ci-après par le terme de couches d'agent absorbant à chalcopyrite.

Dans le cadre de cette filière d'agent absorbant à chalcopyrite, les électrodes arrières sont la plupart du temps fabriquées à base d'un matériau conducteur tel que du molybdène par exemple.

Or, de hautes performances de cette filière ne peuvent être atteintes que par un contrôle rigoureux de la croissance cristalline de la couche d'agent absorbant, et de sa composition chimique.

De plus, on sait que parmi tous les facteurs qui y contribuent, la présence de sodium (Na) sur la couche de Mo est un paramètre-clé qui favorise la cristallisation des agents absorbants à chalcopyrites. Sa présence en quantité contrôlée permet de réduire la densité de défauts de l'absorbeur et d'augmenter sa conductivité.

Le substrat à fonction verrière contenant des alcalins, généralement à base de verre silico-sodo-calcique, constitue naturellement un réservoir de sodium. Sous l'effet du procédé de fabrication des couches de l'agent absorbant, généralement mis en oeuvre à haute température, les alcalins vont migrer au travers du substrat, de l'électrode arrière à base de molybdène, vers la couche d'agent absorbant, notamment de type à chalcopyrite. La couche en molybdène laisse diffuser librement le sodium du substrat vers les couches actives supérieures sous l'effet d'un recuit thermique. Cette couche de Mo présente malgré tout l'inconvénient de ne permettre qu'un contrôle partiel et peu précis de la quantité de Na qui migre à l'interface Mo/CIGSe₂.

Selon une variante de réalisation, la couche d'agent absorbant est déposée, à haute température, sur la couche à base de molybdène, qui est séparée du substrat à l'aide d'une couche barrière à base de nitrures, d'oxydes ou d'oxynitrures de silicium, ou d'oxydes ou d'oxynitrures d'aluminium ou de nitrure de titane ou de zirconium. Cette couche barrière permet de bloquer la diffusion du sodium issu de la diffusion au sein du substrat vers les couches actives supérieures déposées sur le Mo.

Bien qu'ajoutant une étape supplémentaire au procédé de fabrication, cette dernière solution offre la possibilité de doser de manière très précise la quantité de Na déposée sur la couche de Mo en ayant recours à une source extérieure (ex : NaF, Na₂O₂, Na₂Se).

D'autres familles d'agent absorbant, en couches minces, peuvent être utilisées dans des éléments capables de collecter de la lumière. On connaît notamment celles à base de silicium, ce dernier pouvant être amorphe ou microcristallin voire cristallin, soient celles. à base de tellure de cadmium (CdTe).

Il existe également une autre famille d'agent absorbant à base de wafers de silicium monocristallin ou polycristallin en couche épaisse avec une épaisseur comprise entre 50 µm à 250 µm.

Quelque soit la famille d'agent absorbant, il est constant que le rendement de conversion énergétique sera d'autant plus élevé que la quantité d'énergie lumineuse couvrant la plus grande partie du spectre solaire, à savoir de l'ultra violet jusqu'au proche infrarouge en passant par le domaine des longueurs d'onde du visible sera absorbée par l'agent absorbant pour être convertie en énergie électrique. Partant de ce constat, les fabricants de cellule photovoltaïque recherche à piéger le maximum de rayonnement lumineux au sein de la cellule, y compris à renvoyer le moindre rayonnement non absorbé, c'est-à-dire ceux qui sont réfléchis vers l'agent absorbant.

Dans cette recherche de l'optimum de conversion énergétique, les inventeurs ont découvert de manière surprenante et inattendue que la structure de l'électrode en contact avec la couche d'agent absorbant jouait un rôle primordial.

La présente invention vise donc à pallier ces inconvénients en proposant une électrode perfectionnée qui maximise le rayonnement incident vers l'agent absorbant.

A cet effet, le substrat à fonction verrière est décrit dans la revendication 1.

Grâce à la présence de zones d'interfaces entre les couches formant l'électrode, il se crée des sauts d'indice de réfraction à chaque interface qui améliore la réflexion d'un rayonnement incident vers l'agent absorbant.

Dans des modes de réalisation préférés de l'invention, on peut éventuellement avoir recours en outre à l'une et/ou à l'autre des dispositions suivantes :
- il comporte sur au moins une portion de surface de la face principale au moins une couche barrière aux alcalins, l'électrode étant déposée sur ladite couche barrière
- la couche barrière est à base d'un matériau diélectrique,
- le matériau diélectrique est à base de nitrures, d'oxydes ou d'oxynitrures de silicium, ou de nitrures, d'oxydes ou d'oxynitrures d'aluminium ou de nitrures de titane ou de zirconium, utilisés seul ou en mélange,
- l'épaisseur de la couche barrière est comprise entre 3 et 200nm préférentiellement comprise entre 20 et 150 nm et sensiblement voisine de 130 nm,
- la couche barrière est à base de nitrure de silicium.
- La couche à base de nitrure de silicium est sous-stoechiométrique.
- La couche à base de nitrure de silicium est sur-stoechiométrique.

Selon un autre aspect de l'invention, elle vise également un élément capable de collecter de la lumière utilisant au moins un substrat tel que précédemment décrit.

D'autres caractéristiques, détails, avantages de la présente invention apparaîtront mieux à la lecture de la description qui va suivre, faite à titre illustratif et nullement limitatif, en référence à des figures annexées sur lesquelles :
- la figure 1 est vue schématique d'un élément capable de collecter de la lumière selon l'invention,
- la figure 2 est un graphe montrant l'évolution de la réflectivité en fonction du nombre de couches constituant l'électrode, pour une épaisseur constante de couche,
- la figure 3 est un graphe montrant l'évolution de la réflectivité en fonction du nombre de couches constituant l'électrode, à nombre de couche constant

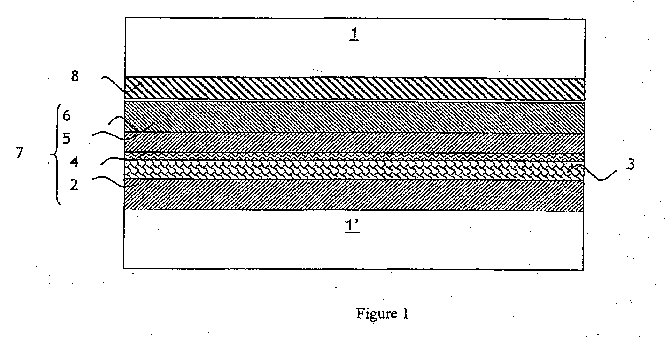

Sur la figure 1, on a représenté un élément capable de collecter de la lumière (une cellule solaire ou photovoltaïque).

Le substrat 1 transparent à fonction verrière peut par exemple être entièrement en verre contenant des alcalins comme un verre silico-sodo-calcique. Il peut également être en un polymère thermoplastique tel qu'un polyuréthane ou un polycarbonate ou un polyméthacrylate de méthyle.

L'essentiel de la masse (c'est-à-dire pour au moins 98 % en masse), voire la totalité du substrat à fonction verrière est constituée de matériau(x) présentant la meilleure transparence possible et ayant de préférence une absorption linéique inférieure à 0,01 mm⁻¹ dans la partie du spectre utile à l'application (module solaire), généralement le spectre allant de l'ultraviolet (environ 280 nm) au proche infrarouge (sensiblement voisin de 1200 nm).

Le substrat 1 selon l'invention peut avoir une épaisseur totale allant de 0,5 à 10 mm lorsqu'on l'utilise comme plaque protectrice d'une cellule photovoltaïque de diverses technologies chalcopyrites (CIS, CIGS, CIGSe₂...) ou en tant que substrat support 1' destiné à recevoir l'ensemble de l'empilement fonctionnel. Lorsque le substrat 1 est utilisé comme plaque protectrice, il peut être avantageux de faire subir à cette plaque un traitement thermique (du type trempe par exemple) lorsqu'il est en verre.

De manière conventionnelle, on définit par A la face avant du substrat dirigée vers les rayons lumineux (il s'agit de la face externe), et par B la face arrière du substrat dirigée vers le reste des couches du module solaire (il s'agit de la face interne).

La face B du substrat 1' est revêtue d'une première couche conductrice 2 devant servir d'électrode. Sur cette électrode 2 est déposée la couche fonctionnelle 3 à base d'agent absorbant à chalcopyrite. Lorsqu'il s'agit d'une couche fonctionnelle 3 à base par exemple de CIS, CIGS, ou CIGSe₂ il est préférable que l'interface entre la couche fonctionnelle 3 et l'électrode 2 soit à base de molybdène. Une couche conductrice répondant à ces exigences est décrite dans la demande de brevet européen EP1356528.

Selon l'invention, l'électrode en molybdène est en fait constituée d'un empilement de n (n≥2) couches constituées chacune d'un matériau identique.

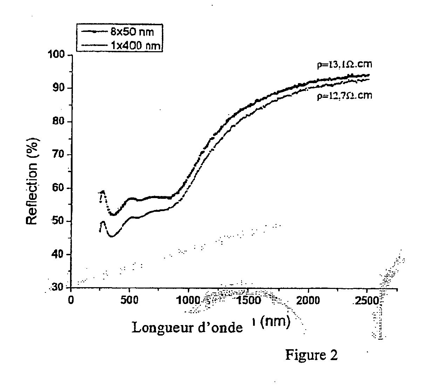

Comme on peut le voir sur le graphe de la figure 2, qui montre l'évolution de la réflectivité sur la totalité du spectre en fonction du nombre de couches constituant l'électrode à base de molybdène. Pour une même épaisseur de molybdène, on constate que plus il y a de couches dans l'empilement, plus la réflectivité est élevée.

On constate également que l'augmentation de la réflectivité (effet recherché) est proportionnelle au nombre de couches constituant l'électrode mais aussi conduit à une augmentation de la résistivité (effet non souhaité)

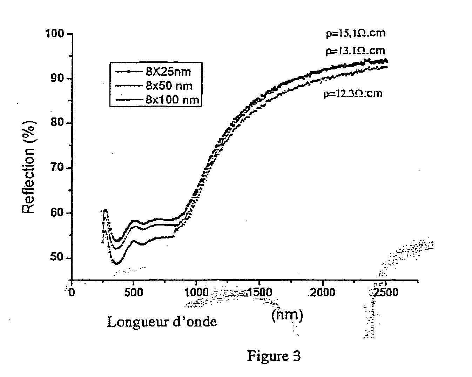

Egalement, on peut voir, à partir de la figure 3, qui montre l'évolution de la réflectivité sur la totalité du spectre en fonction de l'épaisseur de sous-couche, qu'il est préférable d'avoir une électrode privilégiant une épaisseur de sous couche fine pour maximiser la réflectivité au détriment de la résistivité.

En combinant les 2 graphes de la figure 2 et 3, on constate qu'un compromis qui n'est pas selon l'invention peut être trouvé pour un empilement de couches avec n égal à 8 (pour épaisseur totale de la couche en molybdène de 400 nm).

L'électrode à base de molybdène devenant plus réfléchissante, le surplus de photons réfléchis par rapport à une électrode conventionnelle avec un faible nombre de couches contribuent à augmenter le rendement des cellules. Il est aussi possible de réduire l'épaisseur de la couche absorbeur tout en conservant un rendement similaire.

La couche d'agent absorbant à chalcopyrite 3 est revêtue d'une fine couche 4 en sulfure de cadmium (CdS) permettant de créer avec la couche à chalcopyrite 3 une jonction pn. En effet, l'agent chalcopyrite est généralement dopé p, la couche 4 en CdS étant dopée n, cela permet de créer la jonction pn nécessaire à l'établissement d'un courant électrique.

Cette fine couche 4 de CdS est elle-même recouverte d'une couche d'accrochage 5 généralement formée d'oxyde de zinc dit intrinsèque (ZnO : i).

Afin de former la seconde électrode, la couche de ZnO :i 5 est recouverte d'une couche 6 en TCO pour « Transparent Conductive Oxide » . Elle peut être choisie parmi les matériaux suivants : oxyde d'étain dopé, notamment en fluor ou à l'antimoine (les précurseurs utilisables en cas de dépôt par CVD peuvent être des organo-métalliques ou halogénures d'étain associés avec un précurseur de fluor du type acide fluorhydrique ou acide trifluoracétique), l'oxyde de zinc dopé, notamment à l'aluminium ou au bore (les précurseurs utilisables, en cas de dépôt par CVD, peuvent être des organo-métalliques ou halogénures de zinc et d'aluminium), ou encore l'oxyde d'indium dopé, notamment à l'étain (les précurseurs utilisables en cas de dépôt par CVD peuvent être des organo-métalliques ou halogénures d'étain et d'indium). Cette couche conductrice doit être aussi transparente que possible, et présenter une transmission élevée de la lumière dans l'ensemble des longueurs d'onde correspondant au spectre d'absorption du matériau constituant la couche fonctionnelle, afin de ne pas réduire inutilement le rendement du module solaire.

On a constaté que la couche relativement mince 5 (par exemple 100 nm) en ZnO diélectrique (ZnO :i) entre la couche fonctionnelle 3 et la couche conductrice dopée n, par exemple en CdS , influençait de façon positive la stabilité du procédé de dépôt de la couche fonctionnelle.

La couche conductrice 6 présente résistance par carré d'au plus 30 ohms/carré, notamment d'au plus 20 ohms/carré, de préférence d'au plus 10 ou 15 ohms/carré. Elle est généralement comprise entre 5 et 12 ohms/carré.

L'empilement 7 de couches minces est emprisonné entre deux substrats 1 et 1' par l'intermédiaire d'un intercalaire de feuilletage 8 par exemple en PU, PVB ou EVA. Le substrat 1' se distingue du substrat 1 par le fait qu'il est en verre, à base d'alcalins, comme un verre silico-sodo-calcique ou un verre à faible teneur en sodium de manière à conformer une cellule solaire ou photovoltaïque puis encapsulé périphériquement à l'aide d'un joint ou d'une résine d'étanchéité. Un exemple de composition de cette résine et de ses modalités de mise en oeuvre est décrit dans la demande EP739042.

Selon une caractéristique de l'invention, on prévoit de déposer sur toute ou partie de la face du substrat 1 ' et avant de déposer l'électrode 2, notamment à base de molybdène, une couche 9 barrière aux alcalins. Cette couche barrière 9 aux alcalins est à base d'un matériau diélectrique, ce matériau diélectrique étant à base de nitrures, d'oxydes ou d'oxynitrures de silicium, ou de nitrures, d'oxydes ou d'oxynitrures d'aluminium ou de nitrures de titane ou de zirconium, utilisés seul ou en mélange. L'épaisseur de la couche barrière est comprise entre 3 et 200 nm préférentiellement comprise entre 20 et 150nm et sensiblement voisine de 130 nm,

Dans ce cas la teneur en Na du verre n'a que très peu d'impact du fait de la présence de la barrière. On préfèrera utiliser un verre de type sodocalcique pour des raisons économiques mais un verre à faible teneur en Na ou de type borosilicate peut également être utilisé.

Cette couche barrière aux alcalins, par exemple, à base de nitrure de silicium, peut ne pas être stoechiométrique. Elle peut être de nature sous-stoechiométrique, voire et de manière préférée sur-stoechiométrique. Par exemple cette couche est du SiₓN_{y}, avec un rapport x/y d'au moins 0.76, préférentiellement compris entre 0.80 et 0.90, car il a été démontré que lorsque SiₓN_{y} est riche en Si, l'effet barrière aux alcalins est d'autant plus efficace.

L'ajustement de la stoechiométrie peut par exemple être obtenu en faisant varier la pression d'azote dans la chambre de pulvérisation au moment du dépôt des couches par pulvérisation cathodique magnétron réactive d'une cible métallique.

La couche barrière 9 est déposée avant le dépôt des empilements à base de Molybdène, par pulvérisation magnétron de type sputter down ou sputter up. Un exemple de ce procédé de réalisation est donné par exemple dans le brevet EP 1179 516. La couche barrière peut également être déposée par les procédés CVD comme la PE-CVD (Plasma Enhanced Chemical Vapor Déposition).

Parmi toutes les combinaisons possibles, la solution la plus simple est un procédé en une seule étape, l'ensemble des couches est déposé dans le même « coater » (appareil pour la pulvérisation magnétron) .

Un module solaire tel que précédemment décrit, doit, pour pouvoir fonctionner et délivrer une tension électrique à un réseau de distribution électrique, être d'une part, pourvu de dispositifs de connexions électriques et d'autre part, pourvu de moyens de support et de solidarisation assurant son orientation par rapport au rayonnement lumineux.

## Revendications

1. Substrat (1, 1') à fonction verrière comprenant une face principale destinée à être associée à une couche (3) à base d'un matériau absorbant, comportant sur au moins une portion de surface de la face principale au moins une électrode (2) conductrice de l'électricité et réfléchissante dans le domaine des longueurs d'onde s'étendant depuis l'ultraviolet jusqu'au proche infrarouge, ladite électrode (2) étant à base de molybdène, ladite électrode (2) étant formée d'un empilement de n (avec n ≥ 2) couches définissant entre elles des zones d'interfaces, **caractérisé en ce que** l'électrode (2) comprend entre 8 à 16 couches, chacune des couches formant électrode (2) comportant un matériau identique, chacune des couches formant l'électrode (2) possédant une épaisseur sensiblement identique, l'électrode (2) étant à base de molybdène d'au plus 200 nm d'épaisseur.

2. Substrat (1, 1') selon l'une quelconque des revendications précédentes, **caractérisé en ce qu'**il comporte sur au moins une portion de surface de la face principale au moins une couche barrière aux alcalins, l'électrode (2) étant déposée sur ladite couche barrière.

3. Substrat (1, 1') selon la revendication précédente, **caractérisé en ce que** la couche barrière est à base d'un matériau diélectrique.

4. Substrat (1, 1') selon la revendication précédente, **caractérisé en ce que** le matériau diélectrique est à base de nitrures, d'oxydes ou d'oxynitrures de silicium, ou de nitrures, d'oxydes ou d'oxynitrures d'aluminium, ou de nitrure de titane ou de zirconium utilisés seul ou en mélange.

5. Substrat (1, 1') selon l'une des revendications 2 à 4, **caractérisé en ce que** l'épaisseur de la couche barrière est comprise entre 3 et 200nm préférentiellement comprise entre 20 et 150nm et sensiblement voisine de 130 nm.

6. Substrat (1, 1') selon l'une des revendications 2 à 5, **caractérisé en ce que** la couche barrière est à base de nitrure de silicium.

7. Substrat (1, 1') selon l'une des revendications 2 à 6, **caractérisé en ce que** la couche à base de nitrure de silicium est sous-stoechiométrique.

8. Substrat (1, 1') selon l'une des revendications 2 à 7, **caractérisé en ce que** la couche à base de nitrure de silicium est sur-stoechiométrique.

9. Elément capable de collecter de la lumière utilisant au moins un substrat (1, 1') selon l'une quelconque des revendications précédentes.

10. Procédé de fabrication du substrat selon l'une quelconque des revendications 1 à 8, **caractérisé en ce que** la couche barrière et la couche électroconductrice (2) sont déposées à l'aide d'un procédé de pulvérisation magnétron.

## Patentansprüche

1. Substrat (1, 1') mit Verglasungsfunktion, das eine Hauptfläche aufweist, die dazu bestimmt ist, einer Schicht (3) auf Basis eines absorbierenden Materials zugeordnet zu werden, umfassend auf wenigstens einem Flächenabschnitt der Hauptfläche wenigstens eine elektrisch leitende Elektrode (2), die im Wellenlängenbereich vom Ultravioletten bis zum nahen Infrarot reflektierend ist, wobei die Elektrode (2) auf Molybdänbasis ist, wobei die Elektrode (2) von einer Aufschichtung von n (mit n ≥ 2) Schichten gebildet ist, die zwischen sich Schnittstellenbereiche definieren, **dadurch gekennzeichnet, dass** die Elektrode (2) zwischen 8 und 16 Schichten umfasst, wobei eine jede der die Elektrode (2) bildenden Schichten ein identisches Material umfasst, wobei eine jede der die Elektrode (2) bildenden Schichten eine im Wesentlichen identische Dicke aufweist, wobei die Elektrode (2) auf der Basis von Molybdän mit einer Dicke von höchstens 200 nm ist.

2. Substrat (1, 1') nach Anspruch 1, **dadurch gekennzeichnet, dass** es auf wenigstens einem Flächenabschnitt der Hauptfläche wenigstens eine Alkali-Barriereschicht umfasst, wobei die Elektrode (2) auf der Barriereschicht abgeschieden ist.

3. Substrat (1, 1') nach dem vorhergehenden Anspruch, **dadurch gekennzeichnet, dass** die Barriereschicht auf Basis eines dielektrischen Materials ist.

4. Substrat (1, 1') nach dem vorhergehenden Anspruch, **dadurch gekennzeichnet, dass** das dielektrische Material auf der Basis von Siliziumnitriden, -oxiden oder -oxinitriden oder von Aluminiumnitriden, -oxiden oder -oxinitriden oder von Titan- oder Zirkoniumnitrid, allein oder in Mischung verwendet, ist.

5. Substrat (1, 1') nach einem der Ansprüche 2 bis 4, **dadurch gekennzeichnet, dass** die Dicke der Barriereschicht im Bereich zwischen 3 und 200 nm, vorzugsweise zwischen 20 und 150 nm liegt und im Wesentlichen nahe 130 nm beträgt.

6. Substrat (1, 1') nach einem der Ansprüche 2 bis 5, **dadurch gekennzeichnet, dass** die Barriereschicht auf der Basis von Siliziumnitrid ist.

7. Substrat (1, 1') nach einem der Ansprüche 2 bis 6, **dadurch gekennzeichnet, dass** die Schicht auf Siliziumnitridbasis unterstöchiometrisch ist.

8. Substrat (1, 1') nach einem der Ansprüche 2 bis 7, **dadurch gekennzeichnet, dass** die Schicht auf Siliziumnitridbasis überstöchiometrisch ist.

9. Element, das in der Lage ist, Licht zu sammeln, das wenigstens ein Substrat (1, 1') nach einem der vorhergehenden Ansprüche verwendet.

10. Verfahren zur Herstellung des Substrats nach einem der Ansprüche 1 bis 8, **dadurch gekennzeichnet, dass** die Barriereschicht und die elektrisch leitende Schicht (2) mit Hilfe eines Magnetron-Zerstäubungsverfahrens abgeschieden werden.

## Claims

1. Substrate (1, 1') having a glass function, comprising a main face intended to be combined with a layer (3) based on an absorbent material, comprising, on at least one surface portion of the main face, at least one electrically conductive electrode (2) that reflects in the wavelength range extending from the ultraviolet to the near infrared, said electrode (2) being based on molybdenum, said electrode (2) being formed from a stack of n layers (where n ≥ 2) defining between them interface zones, **characterized in that** the electrode (2) comprises between 8 and 16 layers, each of the layers forming the electrode (2) comprising an identical material, each of the layers forming the electrode (2) possessing an approximately identical thickness, the electrode (2) based on molybdenum being at most 200 nm in thickness.

2. Substrate (1, 1') according to any one of the preceding claims, **characterized in that** it includes, over at least one surface portion of the main face, at least one alkali barrier layer, the electrode (2) being deposited on said barrier layer.

3. Substrate (1, 1') according to the preceding claim, **characterized in that** the barrier layer is based on a dielectric material.

4. Substrate (1, 1') according to the preceding claim, **characterized in that** the dielectric material is based on silicon nitrides, oxides or oxynitrides, or on aluminum nitrides, oxides or oxynitrides, or on titanium or zirconium nitride, these being used alone or in a mixture.

5. Substrate (1, 1') according to one of Claims 2 to 4, **characterized in that** the thickness of the barrier layer is between 3 and 200 nm, preferably between 20 and 150 nm and substantially close to 130 nm.

6. Substrate (1, 1') according to one of Claims 2 to 5, **characterized in that** the barrier layer is based on silicon nitride.

7. Substrate (1, 1') according to one of Claims 2 to 6, **characterized in that** the layer based on silicon nitride is substoichiometric.

8. Substrate (1, 1') according to one of Claims 2 to 7, **characterized in that** the layer based on silicon nitride is superstoichiometric.

9. Element capable of collecting light using at least one substrate (1, 1') according to any one of the preceding claims.

10. Process for manufacturing a substrate according to any one of Claims 1 to 8, **characterized in that** the barrier layer and the electroconductive layer (2) are deposited using a magnetron sputtering process.
